# EUROPÄISCHE PATENTSCHRIFT

(11) **EP 1 528 977 B1**
(45) Veröffentlichungstag und Bekanntmachung des Hinweises auf die Patenterteilung: **25.03.2009**
(21) Anmeldenummer: 03793729.9
(22) Anmeldetag: 12.08.2003
(51) Int. Cl.: B32B 7/08, B32B 37/00, B32B 33/00, G01N 27/407, H05K 3/38

(54) **VERFAHREN ZUR HERSTELLUNG EINER FESTEN VERBINDUNG ZWEIER SCHICHTEN EINES MEHRSCHICHTENSYSTEMS SOWIE MEHRSCHICHTENSYSTEM**
METHOD FOR THE PRODUCTION OF A FIXED CONNECTION BETWEEN TWO LAYERS OF A MULTILAYER SYSTEM, AND MULTILAYER SYSTEM
PROCEDE PERMETTANT DE RELIER SOLIDEMENT DEUX COUCHES D'UN SYSTEME MULTICOUCHE ET SYSTEME MULTICOUCHE

(30) Priorität: 13.08.2002 DE 10237013
(43) Veröffentlichungstag der Anmeldung: 11.05.2005
(73) Patentinhaber: Micronas GmbH, 79108 Freiburg i. Br. (DE)
(72) Erfinder: FRERICHS, Heinz, Peter, 79271 St. Peter (DE); VERHOEVEN, Herbert, 72127 Kusterdingen (DE)
(74) Vertreter: Patentanwälte Westphal, Mussgnug & Partner
(86) Internationale Anmeldenummer: PCT/EP2003/008913
(87) Internationale Veröffentlichungsnummer: WO 2004/022332

(56) Entgegenhaltungen:
- EP-A- 0 875 360
- WO-A-01/99155
- US-A- 4 610 042
- US-A- 5 476 003
- US-A- 6 060 009

## Beschreibung

Die Erfindung betrifft ein Verfahren zur Herstellung einer festen Verbindung zweier Schichten eines Mehrschichtensystems mittels Verankerungselementen, welches mindestens einen Ätzschritt aufweist, sowie ein unter Verwendung mindestens eines Ätzschritts hergestelltes Mehrschichtensystem aus mindestens zwei Schichten.

Mehrschichtensysteme sind aus mindestens zwei aneinander haftende Schichten aufgebaut und dienen z. B. als Sensoren zur Detektion von Stoffen wie z. B. Gasen. Diejenigen Schichten, welche den Stoff detektieren, werden als Funktonalschichten bezeichnet.

Ein erster schwerer Nachteil derartiger Funktonalschichten liegt darin, dass sie nicht mit genügend hoher Festigkeit aneinander haften. Es ist daher zwischen zwei Funktonalschichten eine zusätzliche eine höhere Haftwirkung erzielende Dritte Schicht erforderlich, die jedoch einen zweiten Nachteil bedingt, der darin begründet liegt, dass die Dritte Schicht die Funktionalität der Funktionalschichten beträchtlich verringert.

Beispielsweise ist bei einem Wasserstoffsensor eine möglichst reine Grenzfläche zwischen der einen Funktionalschicht aus Palladium und der anderen Funktonalschicht aus Siliziumnitrit für eine ausreichende Messgenauigkeit erforderlich. Doch leider haften diese beiden Funktionalschichten überhaupt nicht aneinander, so dass zwischen diesen beiden Funktionalschichten eine Dritte Schicht gewissermaßen als Klebstoff vorzusehen ist, die sowohl an der einen als auch an der anderen Funktionalschicht gut haftet. Hierfür eignet sich bei diesem Beispiel gut Nickel, das aber die Funktionalität eines Wasserstoffsensors stark beeinträchtigt oder sogar vollständig aufhebt.

Einerseits sollten die Funktionalschichten fest aneinander haften, andererseits aber darf deren Funktionalität nicht beeinträchtigt werden.

Das in der DE 42 40 996 C1 beschriebene Verfahren ist aus diesem Grund im Allgemeinen nicht anwendbar. Hierin werden zwei Schichten mittels einer dazwischen angebrachten Kleberschicht verbunden, die punktuell mit Inseln aus schnell abbindendem Schmelzkleber durchsetzt ist. Diese Schmelzkleberinseln dienen dazu, die Schichten bis zur Auswertung der großflächig aufgebrachten Kleberschicht übereinander zu fixieren. Mit makroskopisch dicken Kleberschichten ist dieses Verfahren gut für die Verbindung von Schaltungsanordnungen mit einer Leiterplatte geeignet, zur Verwendung von Funktionalschichten hingegen weniger, da hier die dicken Kleberschichten die Funktionalität der Bauelemente beeinträchtigen. Des Weiteren setzt dieses Verfahren voraus, dass.ein Material bekannt ist, mit dem eine haftfeste Verbindung zwischen den verschiedenen Schichten hergestellt werden kann.

Weiterhin wird in der DE 28 21 303 B1 ein Verfahren zum Verbinden eines isolierenden Substrats mit einem Metallüberzug beschrieben, bei dem das isolierende Substrat eine speziell chemische Zusammensetzung aufweist. Diese ermöglicht einen selektiven Ätzvorgang, durch welchen Vertiefungen in das isolierende Substrat eingebracht werden und somit dessen Oberfläche vergrößert wird. Nachfolgend wird stromlos ein Metallüberzug auf dem Substrat abgeschieden, welcher auf Grund der Mulden bzw. der vergrößerten Oberfläche des Substrats eine festere Verbindung mit diesem eingeht. Nachteilig bei diesem Verfahren ist, dass es nur für solche Schichtsysteme angewandt werden kann, bei welchen die erforderliche Haftungskraft durch eine Vergrößerung der Haftfläche erzielt werden kann. Haften jedoch die Materialien der beiden Schichten generell nicht aufeinander bzw. ist die erforderliche Haftkraft auch nach Vergrößerung der Oberfläche nicht erreicht, so führt dieses Verfahren nicht zum gewünschten Erfolg.

In ähnlicher Weise nutzt das Verfahren aus der DE 197 18 177 A1 eine Vergrößerung der Oberfläche eines Substrats zur Verbesserung der Haftung zwischen diesem Substrat und einer aufzubringenden Schicht. Zur Oberflächenvergrößerung werden hier zurächst lichtundurchlässige Partikel auf die Substratoberfläche aufgebracht, wodurch sich eine Maskierung der Substratoberfläche ergibt. In den nichtmaskierten Bereichen erfolgt anschließend z. B. durch Laserbehandlung ein Materialabtrag, was eine Aufrauung der Substratoberfläche zur Folge hat. Nach Entfernung der maskierten Partikel wird die zweite Schicht auf die Substratoberfläche aufgebracht und es ergibt sich auf Grund der vergrößerten Haftfläche eine festere Verbindung der beiden Schichten. Gegenüber dem oben beschriebenen Verfahren hat dieses den Vorteil, dass bei schrägem Einfall des materialabtragenden Lichts Stege auf der Substratoberfläche verbleiben, die sich zur Substratoberfläche hin verjüngen. Wird im Anschluss die zweite Schicht auf das Substrat aufgebracht, so ergibt sich eine Art Keilverzahnung zwischen Substrat und der zweiten Schicht, was eine erhöhte Haftung zur Folge und insbesondere eine Verbindung von zwei Schichten ermöglicht, die anderenfalls nicht aufeinander haften würden. Verfahrensbedingt bestehen die als Verankerungselemente dienenden Stege aus demselben Material wie das Substrat. Infolgedessen ist bei schlechter bzw. gar keiner Haftung der aufzubringenden Schicht auf dem Substrat eine hohe Anzahldichte an keilförmigen Stegen bzw. Verankerungselementen vorzusehen, um eine ausweichende Haftung zwischen den zu verbindenden Schichten zu gewährleisten. Sind die Stege nicht keilförmig ausgeführt, ist eine haftfeste Verbindung der Schichten in diesem Fall nicht möglich.

Es ist nun nicht, wie zu erwarten und meist üblich, Aufgabe der Erfindung, den optimalen Kompromiss zwischen Haftung und Funktionalität zu finden, sondern sowohl maximale Haftung als auch beste Funktionalität miteinander kombiniert zu erzielen.

Verfahrensmäßig wird diese Aufgabe mit den im Anspruch 1 angegebenen Merkmalen dadurch gelöst, dass in mindestens einer der beiden Schichten Verankerungselemente eingebettet werden, die aus einem anderen Material bestehen als die zu verbindenden Schichten. -

Vorrichtungsmäßig wird diese Aufgabe mit den im Anspruch 16 angegebenen Merkmalen dadurch gelöst, dass in mindestens eine der beiden Schichten Verankerungselemente eingebettet sind, die aus einem anderen Material bestehen als die beiden zu verbindenden Schichten.

Die Erfindung sieht vor, in mindestens eine der beiden schlecht aneinander haftenden Schichten Verankerungselemente einzubetten, die aus einem anderen Material gefertigt sind als die zu verbindenden Schichten.

Ein Ausführungsbeispiel der Erfindung sieht weiter vor, auf eine erste Schicht eine gut haftende, die Funktionalität jedoch kaum beeinträchtigende dritte Schicht aufzubringen. Die erfingdungsgemäß vorgesehenen Verankerungselemente sind teilweise in die dritte Schicht und die auf der dritten Schicht angebrachte zweite Schicht eingebettet. Durch diese Maßnahme wird eine gute Haftung der Schichten erzielt, weil die dritte Schicht gut as der unteren Schicht haftet und weil die dritte Schicht und die zweite Schicht mittels der Verankerungselemente mechanisch fest verbunden sind.

Ein weiteres Ausführungsbeispiel sieht vor, dass in einem ersten Verfahrensschritt auf eine erste Schicht zumindest teilweise.eine dritte Schicht aufgebracht wird, in welche mehrere Öffnungen eingebracht werden. Die Öffnungen können beispielsweise in einem Ätz- oder Foto-Ätz-Prozess in die dritte Schicht eingebracht werden. Anschließend werden die Öffnungen mit einer Haftmasse gefüllt. Aus den Öffnungen austretende überflüssige Haftmasse wird entfernt, z. B. durch Wegätzen. In einem weiteren Verfahrensschritt wird die dritte Schicht bis auf eine vorgebbare Mindestdicke abgetragen, beispielsweise durch einen Ätz- oder Foto-Ätz-Prozess. Am Ende dieses Prozesses ragen aus der Haftmasse gebildete Verankerungselemente aus der dritten Schicht. Jetzt wird die zweite Schicht auf die dritte Schicht aufgebracht. Die aus der Haftmasse gebildeten Verankerungselemente sind nun sowohl in die dritte Schicht als auch in die zweite Schicht eingebettet, so dass die zweite Schicht fest mit der dritten Schicht verbunden ist.

Die Öffnungen und somit die von der Haftmasse gebildeten Verankerungselemente können zylinderförmig gestaltet sein. Eine bessere Verankerung wird aber erzielt, wenn die Querschnittsfläche einer Öffnung und somit auch eines aus der Haftmasse gebildeten Verankerungselementes vom einen Ende zum anderen Ende zu- oder abnimmt. Vorzugsweise nimmt die Querschnittsfläche vom Ende der dritten Schicht bis zum Ende der zweiten Schicht hin zu, so dass die Verankerungselemente kegel-, in Form eines Doppelkonus oder konisch gestaltet sind. Durch diese Formgebung wird eine Verzahnung der Verankerungselemente mit der zweiten Schicht erzielt. Dies ist insbesondere dann von Vorteil, wenn die Haftmasse nicht auf der zweiten Schicht haftet, so dass ohne Verzahnung keine Verbindung der Schichten möglich wäre.

Mit diesem Verfahren können zwei Funktionalschichten auf drei verschiedene Weisen miteinander verbunden werden. Stellen die zweite und die dritte Schicht Funktionalschichten dar, so wird die dritte Schicht nur soweit zurückgeätzt, dass diese eine für die Funktionalschicht ausreichende Dicke beibehält. Die erste Schicht dient in diesem Fall nur als Substrat, welches beispielsweise beim Einbringen der Öffnungen in die dritte Schicht mittels eines Ätzprozesses dazu dienen kann, den Ätzprozess zu stoppen, sobald die Öffnungen von der Oberseite der dritten Schicht diese bis zur Unterseite durchsetzen. Haftet die die Verankerungselemente bildende Haftmasse überdies nicht an der dritten Schicht jedoch aber an der ersten, so stellen die an der ersten Schicht haftenden und in der zweiten Schicht eingebetteten Verankerungselemente eine Verbindung zwischen der ersten und zweiten Schicht her, die gleichzeitig eine feste verbindung der dazwischen liegenden als Funktionalschicht wirkenden dritten Schicht mit der anderen Funktionalschicht, d. h. der zweiten Schicht, bewirkt. Haftet hingegen das Material, aus welchem die Verankerungselemente bestehen, in ausreichender Weise auf der dritten Schicht, so ist es nicht erforderlich, dass die Öffnungen diese dritte Schicht durchsetzen. Sie können also beispielsweise kegelförmig ausgerührt sein. In diesem Fall kann, sofern die erste Schicht nicht zum Stoppen eines etwaigen Ätzprozesses erforderlich ist, auf diese im Prinzip verzichtet werden.

Bilden nun die erste und die zweite Schicht das Funktionalschichtensystem und haftet das für die Verankerungselemente verwendete Material ausreichend gut auf der ersten Schicht, so kann die dritte Schicht nach Befüllung der Öffnungen mit der Haftmasse vollständig entfernt werden. Die erste und die zweite Schicht werden sodann durch die Verankerungselemente ohne störende Zwischenschicht miteinander verbunden.

Stellen wiederum die erste und die zweite Schicht die Funktionalschichten dar und haftet das'für die Verankerungselemente eingesetzte Material auf keiner der beiden zu verbindenden Schichten, so wird die dritte Schicht aus einem Material gebildet, das sowohl mit der ersten Schicht wie auch mit den Verankerungselementen eine feste Verbindung eingeht. Im Weiteren wird die dritte Schicht nach Ausbildung der Verankerungselemente nur auf eine Mindestdicke zurückgeätzt, welche durch die erforderliche Verbindungsfestigkeit gegeben ist. Die Verankerungselemente sind so ausgeführt, dass sich ihre Querschnittsfläche zur ersten Schicht hin verringert, damit unter Verwendung des oben erwähnten Verzahnungseffekts eine feste Verbindung der Verankerungselemente bzw. der dritten Schicht mit der zweiten Schicht und somit auch der zweiten Schicht mit der ersten Schicht gewährleistet ist.

Ein weiteres Ausführungsbeispiel der Erfindung sieht einen von der dritten Schicht freien Bereich vor, in welchem die erste und die zweite Schicht, welche die Funktionalschichten darstellen, unmittelbar aneinander grenzen. In diesem Bereich ist die Funktionalität in keinster Weise beeinträchtigt, während durch die außerhalb des freien Bereiches vorgesehenen Verankerungselemente eine gute Haftung erzielt wird. Vorzugsweise wird für die dritte Schicht ein Werkstoff vorgesehen, der einerseits mit der einen Schicht (d.h. ersten oder zweiten Schicht) eine feste physikalische oder chemische Verbindung eingeht, andererseits aber die Funktionalität der beiden Schichten nur gering beeinträchtigt. Neben einer mechanischen Verankerung kann auch die Auswahl des Materials für die Verankerungselemente die Haftung der zweiten Funktionalschicht zusätzlich steigern.

Als dritte Schicht eignet sich besonders gut ein Dielektrikum. Die konische Form der Verankerungselemente wird beispielsweise mit Hilfe von Strukturierungsverfahren erzielt, die anisotrope und isotrope Strukturierung definiert geweichten.

Das erfindungsgemäße Verfahren eignet sich beispielsweise für die Herstellung von Sensoren aus mehreren Schichten, ist aber keineswegs auf diese Anwendung beschränkt. Ebenso lassen sich leitende Schichtverbindungen mit starker Haftung herstellen, wie z. B. Bondpads bei Halbleitern. Bondpads werden meist aus Aluminium gefertigt. Bei Bondpads aus Aluminium darf die Temperatur beim nachfolgenden Herstellungsprozessschritten einen Wert von 400° C nicht übersteigen. Dies gilt insbesondere bei Herstellverfahren von Halbleiterchips der Sensorik. Die vorliegende Erfindung ist jedoch nicht auf dem Einsatz von Bondpads aus Aluminium beschränkt. Alternative Materialien sind denkbar.

Die Erfindung wird anhand der Figuren näher beschrieben und erläutert.

In der Zeichnung zeigen:
- Figur 1: eine erste Funktionalschicht und eine aus einem Dielektrikum gebildete dritte Schicht,
- Figur 2: die erste Funktionalschicht und das Dielektrikum mit eingeprägten Öffnungen,
- Figur 3: die erste Funktionalschicht und das Dielektrikum dessen Öffnungen mit Haftmasse gefüllt sind,
- Figur 4: die erste Funktionalschicht und das Dielektrikum mit den mit Haftmasse gefüllten Öffnungen, wobei übergetretene Haftmasse entfernt ist,
- Figur 5: die erste Funktionalschicht, das auf eine Mindestdicke abgetragene Dielektrikum mit aus der Haftmasse gebildeten Verankerungselementen,
- Figur 6: die erste Funktionalschicht, das Dielektrikum, eine zweite Funktionalschicht und das Dielektrikum und die zweite Funktionalschicht miteinander verankernde Verankerungselemente,
- Figur 7: ein Mehrschichtsystem mit einem Funktionalbereich ohne Dielektrikum und
- Figur 8: ein Mehrschichtsystem mit zylinderförmigen Verankerungselementen.

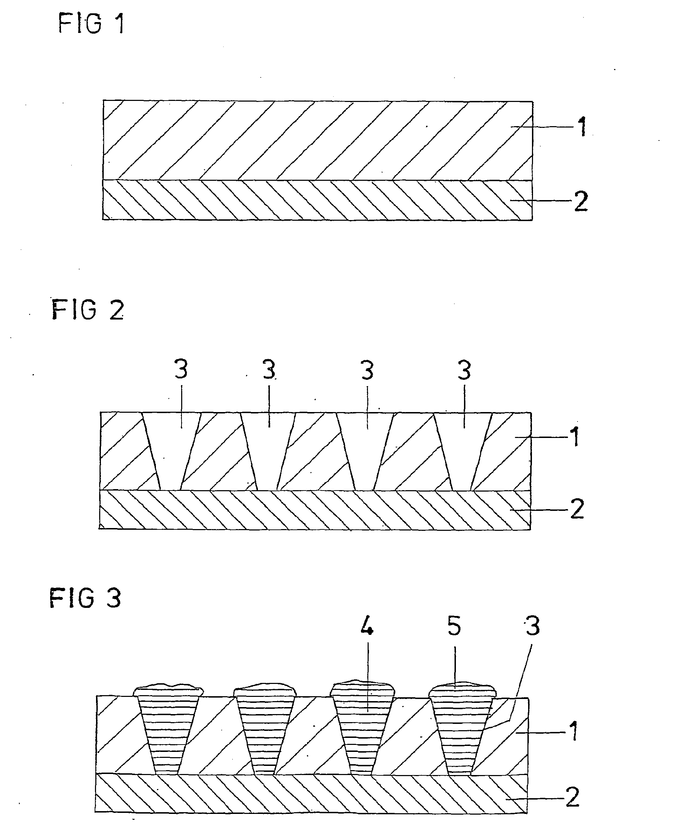

Die Verfahrensschritte eines Ausführungsbeispiels des erfindungsgemäßen Verfahrens werden nun anhand der Figuren 1 bis 6 beschrieben.

Im ersten in Figur 1 dargestellten Verfahrensschritt wird auf eine erste Funktionalschicht 2 ein Dielektrikum 1 aufgebracht, welches hier die dritte Schicht darstellt.

Im zweiten Verfahrensschritt werden, wie in Figur 2 gezeigt ist, in das Dielektrikum 1 Öffnungen 3 eingeprägt, die vorzugsweise konisch oder in Form eines Doppelkonus geformt sind. Die Öffnungen 3 werden beispielsweise durch einen Ätz- oder Foto-Ätz-Prozess in das Dielektrikum 1 eingeprägt.

Im dritten in der Figur 3 dargestellten Verfahrensschritt werden die Öffnungen 3 mit einer Haftmasse 4 gefüllt. Überflüssige aus den Öffnungen 3 austretende Haftmasse 5 wird in einem Ätzprozess entfernt.

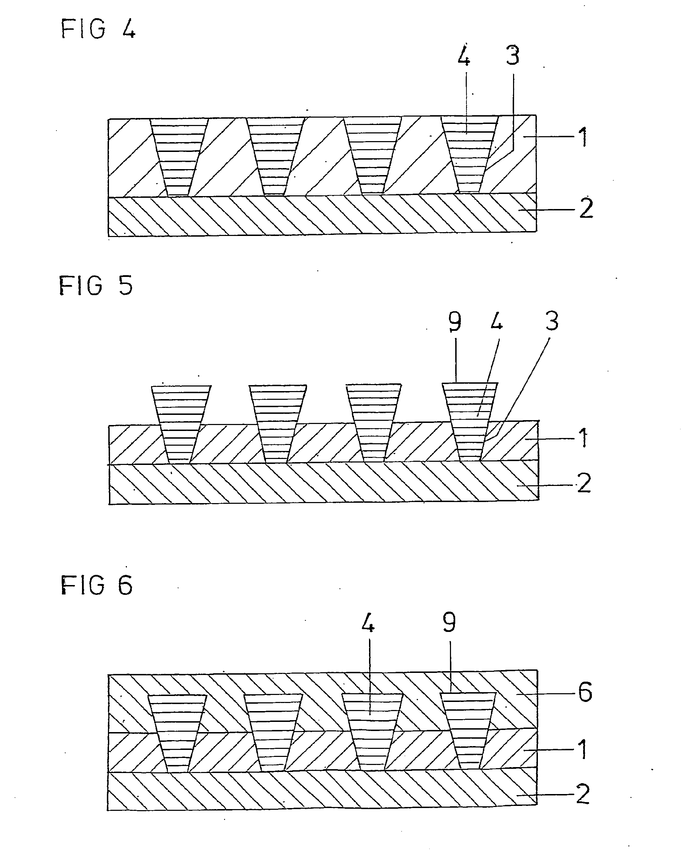

In Figur 4 sind die Funktionalschicht 2, das auf ihr haftende Dielektrikum 1 mit den mit der Haftmasse 4 gefüllten Öffnungen 3 nach dem Wegätzen der überflüssigen Haftmasse 5 gezeigt.

Im folgenden fünften Verfahrensschritt wird das Dielektrikum 1 bis auf eine Mindeststärke abgetragen, beispielsweise durch einen Ätz- oder Foto-Ätz-Prozess. Die aus der Haftmasse 4 gebildeten Verankerungselemente 9 ragen daher mit ihrem oberen Teil aus dem Dielektrikum 1 heraus. In Figur 5 sind die Funktionalschicht 2 sowie das auf ihr haftende Dielektrikum 1 mit den herausragenden Verankerungselementen 9 gezeigt.

Schließlich wird in einem sechsten Verfahrensschritt, dem letzten Verfahrensschritt, die zweite Funktionalschicht 6 auf das Dielektrikum 1 aufgetragen. Die Verankerungselemente 9 sind nun fest in das Dielektrikum 1 und die zweite Funktionalschicht 6 eingebettet und verbinden daher die zweite Funktionalschicht 6 fest mit dem Dielektrikum 1. In Figur 6 ist diese vollständige erfindungsgemäße Anordnung abgebildet.

Ein Dielektrikum eignet sich besonders gut als Dritte Schicht, weil es die Funktionalität nicht beeinträchtigt.

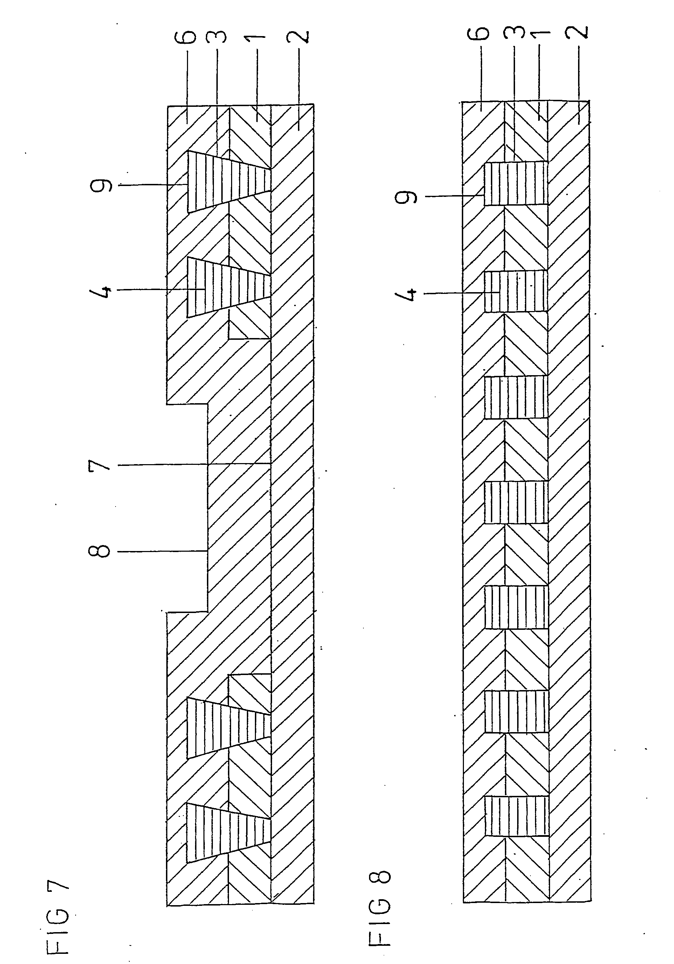

In Figur 7 ist ein weiteres Ausführungsbeispiel der Erfindung abgebildet. Dieses Ausführungsbeispiel unterscheidet sich von dem in Figur 6 gezeigten dadurch, dass ein Bereich 8 vorgesehen ist, der frei vom Dielektrikum 1 ist. In diesem Bereich 8 grenzen die erste Funktionalschicht 2 und die zweite Funktionalschich 6 unmittelbar aneinander. Im Bereich 8 wird daher die maximale Funktionalität erzielt. Neben dem Bereich 8 sind das Dielektrikum 1 und die aus der Haftmasse 4 gebildeten Verankerungselemente 9 angeordnet, welche sowohl im Dielektrikum 1 als auch in der zweiten Funktionalschicht 6 eingebettet sind.

Das in Figur 7 abgebildete Ausführungsbeispiel der Erfindung zeigt deutlich, dass maximale Funktionalität mit maximaler Haftung kombiniert ist.

In Figur 8 ist ein weiteres Ausführungsbeispiel der Erfindung gezeigt.

Auf der ersten Funktionalschicht 2 ist das Dielektrikum 1 angebracht, an das sich die zweite Funktionalschicht 6 anschließt. Die aus der Haftmasse 4 gebildeten Verankerungselemente 9 sind sowohl in das Dielektrikum 1 als auch in die zweite Funktionalschicht 6 eingebettet. Die Verankerungselemente 9 sind zylinderförmig gestaltet und haben daher den Vorteil, dass sie leichter als die konisch geformten Verankerungselemente 9 hergestellt werden können. Jedoch wird mit den zylinderförmigen Verankerungselementen 9 keine so starke Verzahnung erzielt, wie sie mit konisch geformten Verankerungselementen bewirkt wird.

Die Erfindung ist wie bereits erwährt, für mehrschichtige Sensoren und leitende Schichtverbindungen in der Halbleitertechnik geeignet, aber keineswegs auf diese Anwendungsgebiete beschränkt.

In der Halbleitertechnik lassen sich gemäß den erfindungsgemäßen Verfahren Bondpads bei Prozesstemperaturen herstellen, die über 400° C liegen. Die Füllmasse zur Bildung der Verankerungselemente ist das Element wolfram. Die leitenden Schichten, welche den Funktionalschichten entsprechen, sind beispielsweise aus einem Edelmetall hergestellt.

Als geeignete Abmessungen für den Durchmesser und den Abstand der Verankerungselemente haben sich Werte zwischen 100 und 1000 nm als günstig erwiesen. Die Schichtdicken liegen ebenfalls zwischen 100 und 1000 nm. Die Verankerungselemente ragen etwa 20 bis 500 nm aus dem Dielektrikum.

Das erfindungsgemäße Verfahren ist allgemein zur Herstellung von Mehrschichtsystemen geeignet, dessen Schichten nicht gut aneinander haften, jedoch ohne den Nachteil, Dritte Schichten vorsehen zu müssen, welche die Funktionalität eines Mehrschichtensystems in nachteiliger Weise beschränken. Mit der Erfindung lassen sich maximale Funktionalität und maximale Haftwirkung miteinander kombinieren.

### Bezugszeichenliste

- 1: Dielektrikum als dritte Schicht
- 2: Erste Funktionalschicht
- 3: Öffnung
- 4: Haftmasse
- 5: Überflüssige Haftmasse
- 6: Zweite Funktionalschicht
- 7: Reine Grenzschicht zwischen der ersten und zweiten Funktionalschicht
- 8: Von Dielektrikum und Verankerungselementen freier Funktionalbereich
- 9: Verankerungselement

## Patentansprüche

1. Verfahren zur Herstellung einer festen Verbindung zweier Schichten (2, 6; 1, 6) eines Mehrschichtensystems für einen Sensor oder eines Bondpads bei Halbleitern mittels Verankerungselementen (9), welches mindestens einen Ätzschritt aufweist,
**dadurch gekennzeichnet, dass** in mindestens eine der beiden Schichten (2, 6; 1, 6) Verankerungselemente (9) eingebettet werden, die aus einem anderen Material bestehen als die zu verbindenden Schichten.

2. Verfahren nach Anspruch 1,
**dadurch gekennzeichnet, dass** die Verankerungselemente (9) in der zweiten Schicht (6) und in einer zwischen einer ersten Schicht (2) und der zweiten Schicht (6) vorgesehenen dritten Schicht (1) eingebettet werden.

3. Verfahren nach Anspruch 2,
**gekennzeichnet durch** folgende Verfahrensschritte:
- Mindestens teilweises Aufbringen der dritten Schicht (1) auf die erste Schicht (2),
- Einbringen von mehreren Öffnungen (3) in die dritte Schicht (1),
- Vollständiges Füllen der Öffnungen (3) mit einer Haftmasse (4),
- Abtragen der dritten Schicht (1) wird bis auf eine vorgebbare Mindestdicke, so dass aus der Haftmasse (4) gebildete Verankerungselemente (9) aus den Öffnungen (3) der dritten Schicht (1) ragen,
- Aufbringen der zweiten Schicht (6) auf die dritte Schicht (1), wobei diese die aus der Haftmasse (4) gebildete Verankerungselemente (9) vollständig umhüllt.

4. Verfahren nach Anspruch 3,
**dadurch gekennzeichnet, dass** die Querschnittsfläche mindestens einer Öffnung (3) in der dritteln Schicht (1) von einem Ende zum anderen zu- oder abnimmt.

5. Verfahren nach Anspruch 4,
**dadurch gekennzeichnet, dass** die Öffnungen (3) in Form eines Doppelkonus, kegelförmig oder konisch ausgebildet sind.

6. Verfahren nach einem der Ansprüche 3 bis 5,
**dadurch gekennzeichnet, dass** die Öffnungen (3) mittels üblicher Fotolithographie-Ätzprozesse in die dritte Schicht (1) eingebracht werden.

7. Verfahren nach einem der Ansprüche 3 bis 6,
**dadurch gekennzeichnet, dass** eine überstehende Befüllung der Öffnungen (3) erfolgt und die die die dritte Schicht (1) überragende, überflüssige Haftmasse (5) vor dem Abtragen der dritten Schicht (1) bis zur dritten Schicht (1) abgetragen wird.

8. Verfahren nach einem der Ansprüche 3 bis 7,
**dadurch gekennzeichnet, dass** das Abtragen der dritten Schicht (1) in einem Ätz- oder Fotolithographie- Ätzprozess erfolgt.

9. Verfahren nach einem der Ansprüche 2 bis 8,
**daduch gekennzeichnet, dass** mindestens ein von Verankerungselementen (9) und der dritten Schicht (1) freier Bereich (8) vorgesehen wird, in welchem die erste und die zweite Schicht (2, 6) unmittelbar aneinandergrenzen.

10. Verfahren nach einem der Ansprüche 3 bis 9,
**dadurch gekennzeichnet, dass** für die Haftmasse (4) ein Werkstoff vorgesehen wird, der mit der ersten Schicht (2) eine feste physikalische oder chemische Verbindung eingeht.

11. Verfahren nach einem der Ansprüche 3 bis 10,
**dadurch gekennzeichnet, dass** der Durchmesser der Öffnungen (3) in einem Bereich zwischen 100 und 1000 nm liegt.

12. Verfahren nach einem der Ansprüche 3 bis 11,
**dadurch gekennzeichnet, dass** der Abstand der Öffnungen (3) zwischen 100 und 1000 nm beträgt.

13. Verfahren nach einem der Ansprüche 2 bis 12,
**dadurch gekennzeichnet, dass** die Verankerungselement (9) zwischen 20 und 500 nm aus der dritten Schicht (1) ragen.

14. Verfahren nach einem der Ansprüche 1 bis 13,
**dadurch gekennzeichnet, dass** die Schichtdicken 100 bis 1000 nm betragen.

15. Verfahren nach einem der Ansprüche 2 bis 14,
**dadurch gekennzeichnet, dass** die dritte Schicht (1) ein Dielektrikum ist.

16. Unter Verwendung mindestens eines Ätzschritts hergestelltes Mehrschichtensystem für einen Sensor oder eines Bondpads bei Halbleitern aus mindestens einer ersten Schicht (2;1) und einer zweiten Schicht (6),
**dadurch gekennzeichnet, dass** in mindestens einer der beiden Schichten (6) Verankerungselemente (9) eingebettet sind, die aus einem anderen Material bestehen als die beiden Schichten, die sie verbinden.

17. Mehrschichtensystem nach Anspruch 16,
**dadurch gekennzeichnet, dass** die Verankerungselemente (9) in der zweiten Schicht (6) und in einer zwischen einer ersten Schicht (2) und der zweiten Schicht (6) liegenden dritten Schicht (1) eingebettet sind.

18. Mehrschichtsystem nach Anspruch 17,
**dadurch gekennzeichnet, dass** auf die erste Schicht (2) mindestens teilweise die dritte Schicht (1) aufgebracht ist, dass in die dritte Schicht (1) mehrere Verankerungselemente (9) eingebracht sind, welche die dritte Schicht (1) überragen, dass auf die dritte Schicht (1) die zweite Schicht (6) aufgebracht ist, welche die aus der dritten Schicht (1) ragenden Teile der Verankerungselemente umhüllt.

19. Mehrschichtensystem nach einem der Ansprüche 16 bis 18,
**dadurch gekennzeichnet, dass** die Querschnittsfläche mindestens eines Verankerungselements (9) von einem Ende zum anderen Ende zu- oder abnimmt.

20. Mehrschichtensystem nach Anspruch 19,
**dadurch gekennzeichnet, dass** die Verankerungselemente (9) kegelförmig, konisch, oder als Doppelkonus gestaltet sind.

21. Mehrschichtensystem nach einem der Ansprüche 17 bis 20,
**dadurch gekennzeichnet, dass** mindestens ein von der dritten Schicht (1) freier Bereich (8) vorgesehen ist, in welchem die erste und die zweite Schicht (2, 6) unmittelbar aneinander grenzen.

22. Mehrschichtensystem nach einem der Ansprüche 16 bis 21,
**dadurch gekennzeichnet,dass** die Verankerungselemente (9) aus einem Werkstoff bestehen, der mit der ersten Schicht (2) eine feste physikalische oder chemische Verbindung eingeht.

23. Mehrschichtensystem nach einem der Ansprüche 16 bis 22;
**dadurch gekennzeichnet, dass** der Durchmesser der Verankerungselement (9) in einem Bereich zwischen 100 und 1000 nm liegt.

24. Mehrschichtensystem nach einem der Ansprüche 16 bis 23,
**dadurch gekennzeichnet, dass** der Abstand der Verankerungselemente (9) zwischen 100 und 1000 nm beträgt.

25. Mehrschichtensystem nach einem der Ansprüche 16 bis 24,
**dadurch gekennzeichnet, dass** die Verankerungselemente (9) zwischen 20 und 500 nm tief in die zweite Schicht (6) hineinragen.

26. Mehrschichtensystem nach einem der Ansprüche 16 bis 25,
**dadurch gekennzeichnet, dass** die Schichtdicken 100 bis 1000 nm betragen.

27. Mehrschichtensystem nach einem der Ansprüche 17 bis 26,
**dadurch gekennzeichnet, dass** die dritte Schicht (1) aus einem Dielektrikum besteht.

## Claims

1. A method for producing a permanent bond between two layers (2, 6; 1, 6) of a multi-layer system for a sensor or bondpad in semiconductors by means of anchoring elements (9), which method comprises at least one etching step,
**characterised in that** anchoring elements (9) made of a different material to the layers to be bonded are embedded in at least one of the two layers (2, 6; 1, 6).

2. A method according to Claim 1,
**characterised in that** the anchoring elements (9) are embedded in the second layer (6) and in a third layer (1) provided between a first layer (2) and the second layer (6).

3. A method according to Claim 2,
**characterised by** the following method steps:
- at least partial application of the third layer (1) to the first layer (2),
- introduction of several holes (3) into the third layer (1),
- complete filling of the holes (3) with an adhesive compound (4),
- removal of the third layer (1) down to a specifiable minimum thickness, so that anchoring elements (9) formed from the adhesive compound (4) protrude out of the holes (3) in the third layer (1),
- application of the second layer (6) to the third layer (1), whereby said layer completely encloses the anchoring elements (9) made from the adhesive compound (4).

4. A method according to Claim 3,
**characterised in that** the cross-sectional area of at least one hole (3) in the third layer (1) increases or decreases from one end to the other.

5. A method according to Claim 4,
**characterised in that** the holes (3) are designed as a double-cone, tapered or conically.

6. A method according to one of Claim 3 to 5,
**characterised in that the** holes (3) are introduced into the third layer (1) by means of conventional photolithographic etching processes.

7. A method according to one of Claims 3 to 6,
**characterised in that** the holes (3) are filled with protruding compound and the excess adhesive compound (5) protruding above the third layer (1) is stripped down to the third layer (1) prior to the stripping of the third layer (1).

8. A method according to one of Claims 3 to 7,
**characterised in that** stripping of the third layer (1) is carried out in an etching or photolithographic etching process.

9. A method according to one of Claims 2 to 8,
**characterised in that** at least one region (8) devoid of anchoring elements (9) and of the third layer (1) is provided, in which the first and the second layers (2, 6) directly adjoin one another.

10. A method according to one of Claims 3 to 9,
**characterised in that** for the adhesive compound (4) there is provided a material that enters into a permanent physical or chemical bond with the first layer (2).

11. A method according to one of Claims 3 to 10,
**characterised in that** the diameter of the holes (3) lies in a range between 100 and 1000 nm.

12. A method according to one of Claims 3 to 11,
**characterised in that** the spacing of the holes (3) is between 100 and 1000 nm.

13. A method according to one of Claims 2 to 12,
**characterised in that** the anchoring elements (9) protrude by between 20 and 600 nm from the third layer (1).

14. A method according to one of Claims 1 to 13,
**characterised in that** the layer thicknesses are 100 to 1000 nm.

15. A method according to one of Claims 2 to 14,
**characterised in that** the third layer (1) is a dielectric.

16. A multi-layer system for a sensor or a bondpad in semiconductors that is produced using at least one etching step and consisting of at least a first layer (2; 1) and a second layer (6),
**characterised in that** embedded in at least one of the two layers (6) are anchoring elements (9), which are made from a different material to the two layers connecting them.

17. A multi-layer system according to Claim 16,
**characterised in that** the anchoring elements (9) are embedded in the second layer (6) and in a third layer (1) lying between a first layer (2) and the second layer (6).

18. A multi-layer system according to Claim 17,
**characterised in that** the third layer (1) is applied at least partially to the first layer (2),
**in that** into the third layer (1) there are introduced several anchoring elements (9), which project above the third layer (1),
**in that** onto the third layer (1) there is applied the second layer (6), which encloses the parts of the anchoring elements protruding from the third layer (1).

19. A multi-layer system according to one of Claims 16 to 18,
**characterised in that** the cross-sectional area of at least one anchoring element (9) increases or decreases from one end to the other end.

20. A multi-layer system according to Claim 19,
**characterised in that** the anchoring elements (9) are designed tapered, conically or as a double cone.

21. A multi-layer system according to one of Claims 17 to 20,
**characterised in that** there is provided at least one region (8) devoid of the third layer (1), in which region the first and the second layers (2, 6) directly adjoin one another.

22. A multi-layer system according to one of Claims 16 or 21,
**characterised in that** the anchoring elements (9) are made from a material that enters into a permanent physical or chemical bond with the first layer (2).

23. A multi-layer system according to one of Claims 16 to 22,
**characterised in that** the diameter of the anchoring elements (9) lies in a range between 100 and 1000 nm.

24. A multi-layer system according to one of Claims 16 to 23,
**characterised in that** the spacing of the anchoring elements (9) is between 100 and 1000 nm.

25. A multi-layer system according to one of Claims 16 to 24,
**characterised in that** the anchoring elements (9) protrude by between 20 and 500 nm into the second layer (6).

26. A multi-layer system according to one of Claims 16 to 25,
**characterised in that** the layer thicknesses are 100 to 1000 nm.

27. A multi-layer system according to one of Claims 17 to 26,
**characterised in that** the third layer (1) is made from a dielectric.

## Revendications

1. Procédé de réalisation d'une liaison solide entre deux couches (2, 6 ; 1, 6) d'un système à plusieurs couches d'un capteur ou d'une patte de liaison dans des semi-conducteurs par des éléments d'ancrage (9), ce procédé comprenant au moins une étape de gravure,
**caractérisé en ce qu'**
on intègre dans au moins l'une des deux couches (2, 6 ; 1, 6), les éléments d'ancrage (9), formés d'un autre matériau que celui des couches à relier.

2. Procédé selon la revendication 1,
**caractérisé en ce que**
les éléments d'ancrage (9) sont intégrés dans la seconde couche (6) et dans une troisième couche (1) entre la première couche (2) et la seconde couche (6).

3. Procédé selon la revendication 2,
**caractérisé par** les étapes suivantes :
- on applique au moins en partie la troisième couche (1) sur la première couche (2),
- on réalise plusieurs orifices (3) dans la troisième couche (1),
- on remplit complètement les orifices (3) avec une masse adhésive (4),
- on enlève la troisième couche (1) jusqu'à une épaisseur minimale prédéfinie pour que des éléments d'ancrage (9) formés dans la masse d'accrochage (4) dépassent des orifices (3) de la troisième couche (1),
- on applique la seconde couche (6) sur la troisième couche (1), les éléments d'ancrage (9) formés à partir de la masse d'ancrage (4) étant alors complètement enveloppés.

4. Procédé selon la revendication 3,
**caractérisé en ce que**
la section d'au moins une ouverture (3) de la troisième couche (1) diminue ou augmente à partir d'une extrémité vers l'autre.

5. Procédé selon la revendication 4,
**caractérisé en ce que**
les orifices (9) ont une forme de double cône, de cône simple ou une forme conique.

6. Procédé selon l'une des revendications 3 à 5,
**caractérisé en ce qu'**
on réalise les orifices (3) dans la troisième couche (1) par des procédés de photolithogravure usuels.

7. Procédé selon l'une des revendications 3 à 6,
**caractérisé en ce qu'**
on remplit les orifices (3) jusqu'à arriver à la troisième couche (1), de façon à déborder et on enlève la masse d'accrochage (5) superflue qui dépasse de la troisième couche (1) avant d'enlever la troisième couche (1).

8. Procédé selon l'une des revendications 3 à 7,
**caractérisé en ce que**
l'enlèvement de la troisième couche (1) se fait au cours d'une opération de gravure ou de photolithogravure.

9. Procédé selon l'une des revendications 2 à 8,
**caractérisé par**
au moins une zone libre (8) dégagée des éléments d'ancrage (9) et de la troisième couche (1), et dans laquelle la première et la seconde couche (2, 6) sont directement adjacentes.

10. Procédé selon l'une des revendications 3 à 9,
**caractérisé en ce que**
la masse d'accrochage (4), est une matière qui se relie à la première couche (2) pour former une liaison physique ou chimique solide.

11. Procédé selon l'une des revendications 3 à 10,
**caractérisé en ce que**
le diamètre des orifices (3) est dans une plage comprise entre 100 nm et 1000 nm.

12. Procédé selon l'une des revendications 3 à 11,
**caractérisé en ce que**
la distance qui sépare les orifices (3) est comprise entre 100 nm et 1000 nm.

13. Procédé selon l'une des revendications 2 à 12,
**caractérisé en ce que**
l'élément d'ancrage (9) dépasse de la troisième couche (1) de 20 nm à 500 nm.

14. Procédé selon l'une des revendications 1 à 13,
**caractérisé en ce que**
l'épaisseur des couches est comprise entre 100 nm et 1000 nm.

15. Procédé selon l'une des revendications 2 à 14,
**caractérisé en ce que**
la troisième couche (1) est un diélectrique.

16. Système de couches multiples fabriquées en utilisant au moins une étape de gravure pour un capteur ou une patte de liaison (2) de semiconducteur, formé d'au moins une première couche (2 ; 1) et d'une seconde couche (6),
**caractérisé en ce qu'**
au moins l'une des deux couches (6) comporte des éléments d'ancrage (9), intégrés, réalisés en une autre matière que les deux couches qu'ils relient.

17. Système multicouche selon la revendication 16,
**caractérisé en ce que**
les éléments d'ancrage (9) sont intégrés dans la seconde couche (6) et dans une troisième couche (1) située entre la première couche (2) et la seconde couche (6).

18. Système multicouche selon la revendication 17,
**caractérisé en ce que**
la troisième couche (1) est appliquée au moins partiellement sur la première couche (2),
la troisième couche (1) comporte plusieurs éléments d'ancrage (9) qui dépassent de la troisième couche (1),
la seconde couche (6) est appliquée sur la troisième couche (1), et entoure les parties des éléments d'ancrage qui dépassent de la troisième couche (1).

19. Système multicouche selon l'une des revendications 16 à 18,
**caractérisé en ce que**
la surface de la section d'au moins un élément d'ancrage (9) augmente ou diminue à partir d'une extrémité vers l'autre extrémité.

20. Système multicouche selon la revendication 19,
**caractérisé en ce que**
les éléments d'ancrage (9) ont une forme de tronc de pyramide, de cône ou de double cône.

21. Système multicouche selon l'une des revendications 17 à 20,
**caractérisé par**
au moins une zone (8) libre de la troisième couche (1), dans laquelle la première et la seconde couche (2, 6) se touchent directement.

22. Système multicouche selon l'une des revendications 16 à 21,
**caractérisé en ce que**
les éléments d'ancrage (9) sont réalisés en un matériau qui coopère par une liaison physique ou chimique solide avec la première couche (2).

23. Système multicouche selon l'une des revendications 16 à 22,
**caractérisé en ce que**
le diamètre de l'élément d'ancrage (9) est dans une plage comprise entre 100 nm et 1000 nm.

24. Système multicouche selon l'une des revendications 16 à 23,
**caractérisé en ce que**
la distance qui sépare les éléments d'ancrage (9) est comprise entre 100 nm et 1000 nm.

25. Système multicouche selon l'une des revendications 16 à 24,
**caractérisé en ce que**
les éléments d'ancrage (9) pénètrent dans la seconde couche (6) selon une profondeur comprise entre 20 nm et 500 nm.

26. Système multicouche selon l'une des revendications 16 à 25,
**caractérisé en ce que**
les épaisseurs des couches sont comprises entre 100 nm et 1000 nm.

27. Système multicouche selon l'une des revendications 17 à 26,
**caractérisé en ce que**
la troisième couche (1) est un diélectrique.
